# EUROPÄISCHE PATENTSCHRIFT

(11) **EP 0 732 041 B1**
(45) Veröffentlichungstag und Bekanntmachung des Hinweises auf die Patenterteilung: **11.03.1998**
(21) Anmeldenummer: 95901455.6
(22) Anmeldetag: 29.11.1994
(51) Int. Cl.: H05K 7/18

(54) **VERFAHREN ZUM AUFBAU EINES SCHALTSCHRANKES UND ZUM EINBAU VON EINBAUTEN**
PROCESS FOR CONSTRUCTING A SWITCHGEAR CABINET AND FOR INSTALLING INTERIOR COMPONENTS
PROCEDE DE REALISATION D'UNE ARMOIRE ELECTRIQUE ET DE MONTAGE D'ELEMENTS A MONTER DANS LADITE ARMOIRE ELECTRIQUE

(30) Priorität: 01.12.1993 DE 4340934
(43) Veröffentlichungstag der Anmeldung: 18.09.1996
(73) Patentinhaber: Rittal-Werk Rudolf Loh GmbH & Co. KG, 35745 Herborn (DE)
(72) Erfinder: BESSERER, Horst, D-35745 Herborn (DE); MÜNCH, Udo, D-35764 Sinn (DE); NEUHOF, Markus, D-35630 Ehringshausen (DE); NICOLAI, Walter, D-35418 Buseck (DE); PAWLOWSKI, Adam, D-35690 Dillenburg (DE); SCHÜLER, Matthias, D-35716 Dietzhölztal (DE); STRACKBEIN, Heinrich, D-35444 Biebertal (DE)
(74) Vertreter: Fleck, Hermann-Josef, Dr.-Ing.
(86) Internationale Anmeldenummer: EP9403960
(87) Internationale Veröffentlichungsnummer: WO9515675

(56) Entgegenhaltungen:
- EP-A- 0 158 216
- DE-U- 7 211 693
- FR-A- 2 207 402
- MACHINE DESIGN., Bd.58, Nr.26, November 1986, CLEVELAND US Seiten 101 - 106 PAUL J. DVORAK 'Modular enclosures beyond the basic box'

## Beschreibung

Die Erfindung betrifft ein Verfahren zum Aufbau eines Schaltschrankes aus einem Rahmengestell aus Rahmenschenkeln, mindestens einer Schranktür und Wandelementen und zum Einbau und Verdrahten von in dem Schaltschrank unterzubringenden Einbauten, wie Montageplatte, Montageschienen, Baugruppenträger, Installationsgeräten und dgl.

In der Regel werden die Schaltschränke im Herstellerwerk zusammengebaut und als fertiges Produkt an den Einsatzort gebracht, wo der Benutzer die Einbauten einbringt. Dabei ist es durchaus möglich, daß der Hersteller den Schaltschrank schon mit eingebauten Montagehilfen und dgl. versehen hat. Es sei nur auf eingebaute Stromverteilerkomponenten hingewiesen. Die endgültige Bestückung des Schaltschrankes erfolgt jedoch erst am Einsatzort durch den Benutzer.

Es sind auch Bausätze für Schaltschränke bekannt, die raumsparend versandt werden können. Am Einsatzort wird vom Benutzer zuerst der Schaltschrank zusammengesetzt. Nach dem Aufbau des Schaltschrankes wird mit dem Einbau der Einbauten begonnen.

In jedem Fall ist der Einbau und die Verdrahtung der Einbauten in einem fertigen Schaltschrank nicht einfach, da die Zugänglichkeit in dem vom Schaltschrank umschlossenen Raum oft unnötig erschwert ist oder zusätzliche Vorrichtungen, wie Schwenkrahmen, erfordert, um an die eingebauten Einheiten gelangen zu können.

Es ist Aufgabe der Erfindung, ein Verfahren der eingangs erwähnten Art zu schaffen, bei dem die Teile des Schaltschrankes raumsparend versandt und am Einsatzort so zusammengebaut werden können, daß der Einbau der Einbauten auf einfache Weise bei guter Zugänglichkeit möglich ist.

Diese Aufgabe wird nach der Erfindung dadurch gelöst, daß aus vier Rahmenschenkeln ein Grund-Rahmen zusammengesetzt oder ein aus vier Rahmenschenkeln zusammengesetzter vorgefertigter Rahmen verwendet wird, daß an den unteren Ecken des aufgestellten Grund-Rahmens zwei weitere senkrecht dazu stehende Rahmenschenkel angebracht werden und so zunächst ein Teilrahmengestell gebildet wird, daß in das Teilrahmengestell die Einbauten eingebaut und darin verdrahtet werden, wobei das Teilrahmengestell zum Rahmengestell vervollständigt wird und daß zuletzt die Schranktür und die Wandelemente am mit Einbauten versehenen Rahmengestell angebracht werden.

Mit dem am Einsatzort zusammengebauten Teilrahmengestell kann schon mit dem Einbau von Einbauten begonnen werden. Die am Grund-Rahmen senkrecht abstehenden unteren Rahmenschenkel erlauben, daß das Teilrahmengestell aufgestellt werden kann. Der Einbau und die Verdrahtung der Einbauten ist einfach, da das offene Teilrahmengestell allseitigen Zugang zu dem eingentlichen, noch offenen Innenraum des Schaltschrankes gewährt. Abschließend werden dann die Schranktür und die Wandelemente an das vervollständigte Rahmengestell angebracht.

Nach einer bevorzugten Ausgestaltung ist dabei vorgesehen, daß das Teilrahmengestell mit oberen Rahmenschenkeln und mit einem weiteren, vorzugsweise vorgefertigten Rahmen zum Rahmengestell ergänzt wird.

Zur Vervollständigung des Schaltschrankes kann vorgesehen sein, daß die untere Seite des Rahmengestelles mit einem Sockel verbunden wird und daß die untere Seite des Rahmengestelles mit Teilbodenplatten verschlossen wird, die mit Kabeleinführungen versehen sind.

Beim Einbau der Einbauten in das Teilrahmengestell ist eine Ausgegstaltung möglich, die dadurch gekennzeichnet ist, daß eine mit Installationsgeräten bestückte Montageplatte in das Teilrahmengestell eingesetzt und vorzugsweise mit dem Grund-Rahmen verbunden wird. Die Bestückung und Verdrahtung der Montageplatte kann dann außerhalb des Teilrahmengestelles vorgenommen werden.

Der Einbau von Installationsgeräten und dgl. kann dadurch erleichtert werden, daß an dem Teilrahmengestell Montageschienen angebracht werden.

In das Teilrahmengestell können auch Baugruppenträger eingesetzt und darin verdrahtet werden, die später Einschübe aufnehmen.

Die Erfindung wird anhand von einem in den Zeichnungen dargestellten Ausführungsbeispiel näher erläutert. Es zeigen in jeweils perspektivischer Vorderansicht:
- Fig. 1: ein Teilrahmengestell aus einem Grund-Rahmen und zwei Rahmenschenkeln,
- Fig. 2: das Teilrahmengestell mit eingebauter Montageplatte und angebrachten Montageschienen,
- Fig. 3: das vervollständigte Rahmengestell mit den Einbauten und

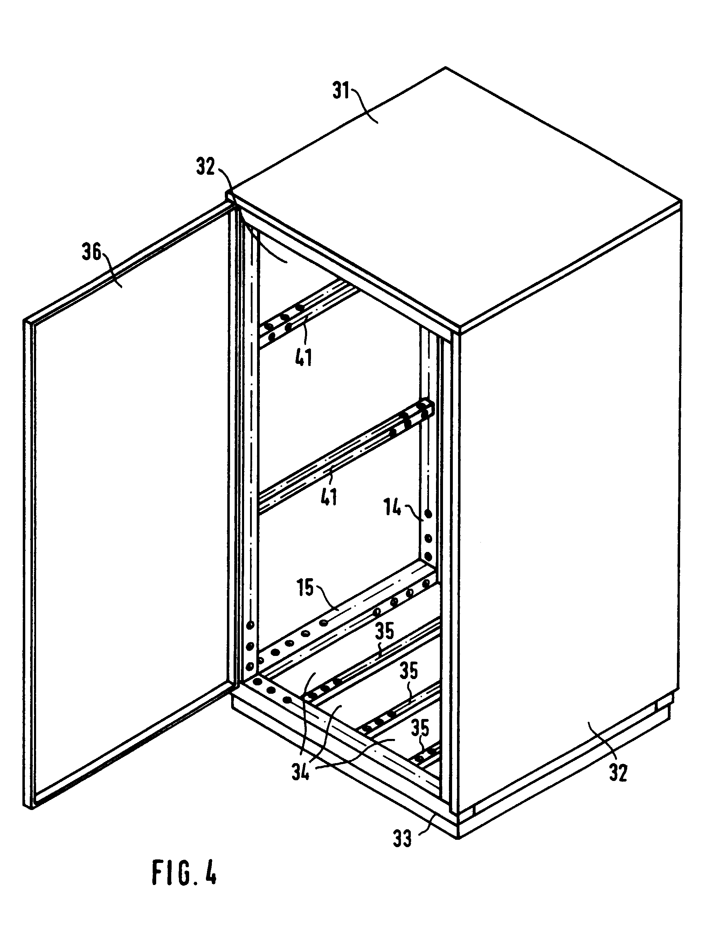

- Fig. 4: den vervollständigten Schaltschrank.

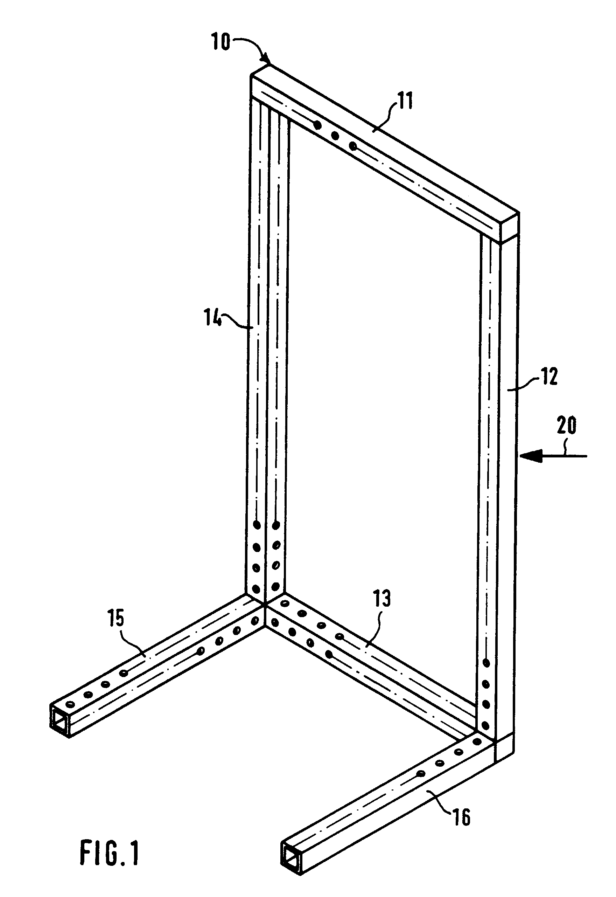

Wie die Fig. 1 zeigt, wird aus den angelieferten Teilen zunächst ein Teilrahmengestell 20 aufgebaut. Dieses Teilrahmengestell 20 umfaßt einen Grund-Rahmen 10 aus vier Rahmenschenkeln 11, 12, 13 und 14, sowie zwei Rahmenschenkeln 15 und 16, die senkrecht abstehend an den unteren Ecken des Grund-Rahmens 10 angebracht sind. Der Grund-Rahmen 10 kann erst am Einsatzort zusammengebaut oder vorgefertigt vom Hersteller geliefert werden. Das Teilrahmengestell 20 kann, wie Fig. 1 zeigt, aufgestellt werden, wobei der Grund-Rahmen 10 vorzugsweise der Rückseite des Schaltschrankes zugekehrt ist.

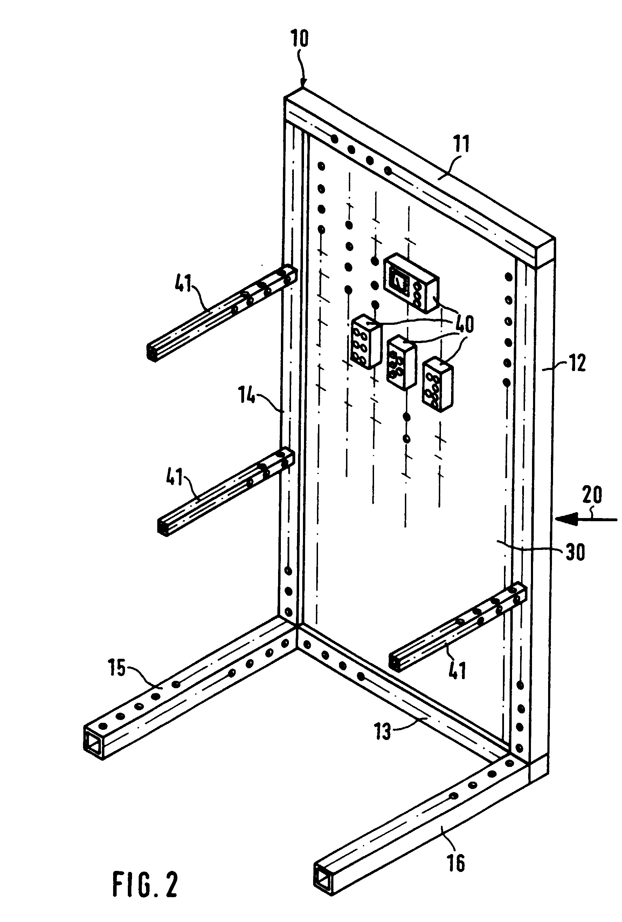

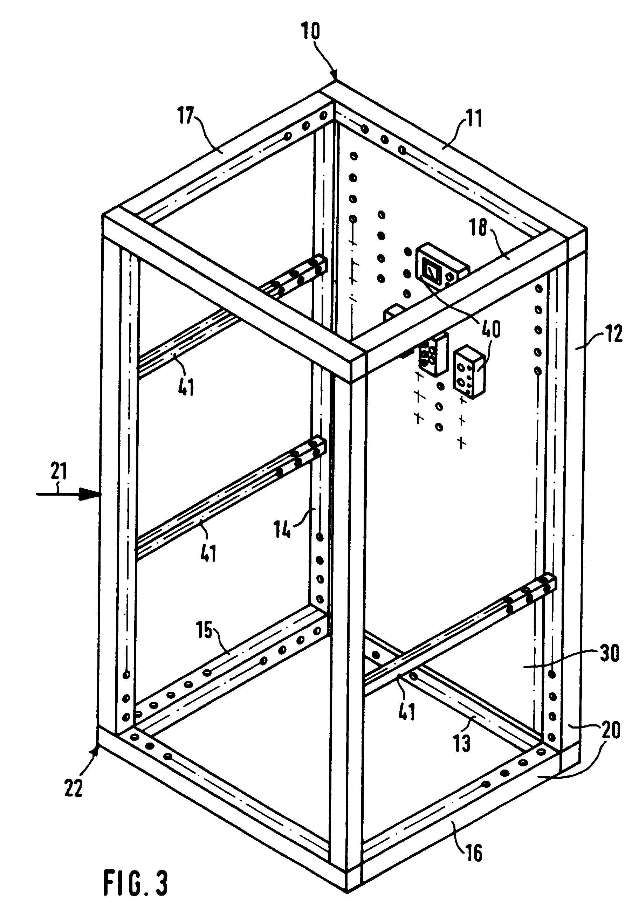

In das Teilrahmengestell 20 können nun ohne Behinderung Einbauten eingesetzt und darin verdrahtet werden. Wie Fig. 2 zeigt, kann z.B. eine mit Installationsgeräten 40 bestückte, verdrahtete Montageplatte 30 in das Teilrahmengestell 20 eingesetzt und mit dem Grund-Rahmen 10 verbunden werden. Außerdem können an dem Grund-Rahmen 10 zusätzliche Montageschienen 41 angebracht werden, die auch als Führungen für ausziehbare Baugruppenträger ausgebildet sein können. Der Einbau von Einbauten ist dem Benutzer überlassen und richtet sich nach dem Verwendungszweck. Das Teilrahmengestell 20 kann nach dem Einbau der Einbauten oder in Verbindung mit diesem zum Rahmengestell 21 vervollständigt werden, wie Fig. 3 zeigt. Dabei werden die oberen Rahmenschenkel 17 und 18 mit dem Grund-Rahmen 10 verbunden und ein weiterer Rahmen 22 vervollständigt das Rahmengestell 21. Der Rahmen 22 wird mit den freien Enden der Rahmenschenkel 15, 16, 17 und 18 und mit den freien Enden der Montageschienen 41 verbunden.

Ist das Rahmengestell 21 komplett und mit allen Einbauten versehen und auch verdrahtet, dann wird am Rahmen 22 des Rahmengestelles 21 die Schranktür 36 angelenkt, mit der die Vorderseite des Rahmengestelles 21 verschlossen werden kann. Die übrigen Seiten und die Oberseite werden mit Wandelementen 32 und 31 verschlossen. Die untere Seite des Rahmengestelles 21 wird mit einem Sockel 33 verbunden und mittels Teilbodenplatten 34 verschlossen. Zwischen den Teilbodenplatten 34 sind Kabeleinführungen 35 vorgesehen.

Die obere Seite des Rahmengestelles kann mit einem Dachaufbau oder dgl. versehen werden, in dem ein Kühlgerät untergebracht sein kann oder über den die Kabeleinführung erfolgen kann.

Das Verfahren nach der Erfindung kann auch so abgewandelt werden, daß mehrere Teilrahmengestelle 20 aneinandergereiht werden, daß die Einbauten 30,40,41 in die Teilrahmengestelle 20 eingebracht und verdrahtet werden, wobei die Teilrahmengestelle 20 zu Rahmengestellen 21 vervollständigt werden und daß die Rahmengestelle 21 mit Schranktüren 36 und Wandelementen 31,32 zu einer Schrankreihe verschlossen werden.

## Patentansprüche

1. Verfahren zum Aufbau eines Schaltschrankes aus einem Rahmengestell aus Rahmenschenkeln, mindestens einer Schranktür und Wandelementen und zum Einbau und Verdrahten von in dem Schaltschrank unterzubringenden Einbauten, wie Montageplatte, Montageschienen, Baugruppenträger, Installationsgeräten und dgl.,
dadurch gekennzeichnet,
daß aus vier Rahmenschenkeln (11, 12, 113, 14) ein Grund-Rahmen (10) zusammengesetzt oder ein aus vier Rahmenschenkeln (11, 12, 13, 14) zusammengesetzter vorgefertigter Grund-Rahmen (10) verwendet wird,
daß an den unteren Ecken des aufgestellten Grund-Rahmens (10) zwei weitere senkrecht dazu stehende Rahmenschenkel (15, 16) angebracht werden und so zunächst ein Teilrahmengestell (20) gebildet wird,
daß in das Teilrahmengestell (20) die Einbauten (30,40,41) eingebaut und darin verdrahtet werden, wobei das Teilrahmengestell (20) zum Rahmengestell (21) vervollständigt wird und
daß zuletzt die Schranktür (36) und die Wandelemente (31, 32) am mit Einbauten (30, 40, 41) versehenen Rahmengestell (21) angebracht werden.

2. Verfahren nach Anspruch 1,
dadurch gekennzeichnet,
daß das Teilrahmengestell (20) mit oberen Rahmenschenkeln (17, 18) und mit einem weiteren, vorzugsweise vorgefertigten Rahmen (22) zum Rahmengestell (21) ergänzt wird.

3. Verfahren nach Anspruch 1 oder 2,
dadurch gekennzeichnet,
daß die untere Seite des Rahmengestelles (21) mit einem Sockel (33) verbunden wird und
daß die untere Seite des Rahmengestelles (21) mit Teilbodenplatten (34) verschlossen wird, die mit Kabeleinführungen (35) versehen sind.

4. Verfahren nach einem der Ansprüche 1 bis 3,
dadurch gekennzeichnet,
daß eine mit Installationsgeräten (40) bestückte Montageplatte (30) in das Teilrahmengestell (20) eingesesetzt und vorzugsweise mit dem Grund-Rahmen (10) verbunden wird.

5. Verfahren nach einem der Ansprüche 1 bis 4,
dadurch gekennzeichnet,
daß an dem Teilrahmengestell (20) Montageschienen (41) angebracht werden.

6. Verfahren nach einem der Ansprüche 1 bis 5,
dadurch gekennzeichnet,
daß in das Teilrahmengestell (20) Baugruppenträger eingesetzt und darin verdrahtet werden.

7. Verfahren nach einem der Ansprüche 1 bis 6,
dadurch gekennzeichnet,
daß die obere Seite des Rahmengestelles (21) mit einem Dachaufbau versehen wird.

8. Verfahren nach einem der Ansprüche 1 bis 7,
dadurch gekennzeichnet,
daß mehrere Teilrahmengestelle (20) aneinandergereiht werden,
daß die Einbauten (30,40,41) in die Teilrahmengestelle (20) eingebracht und verdrahtet werden, wobei die Teilrahmengestelle (20) zu Rahmengestellen (21) vervollständigt werden, und
daß die Rahmengestelle (21) mit Schranktüren (36) und Wandelementen (31,32) zu einer Schrankreihe verschlossen werden.

## Claims

1. Method of constructing a switchgear cabinet from a framework comprising frame portions, at least one cabinet door and wall elements and for installing and wiring components which are to be accommodated in the switchgear cabinet, such as a mounting plate, mounting rails, assembly carriers, installation equipment and the like, characterised in that a basic frame (10) comprises four frame portions (11, 12, 13, 14), or a prefabricated basic frame (10) is used, which comprises four frame portions (11, 12, 13, 14), in that two additional frame portions (15, 16) are attached to the lower corners of the erected basic frame (10) and lie perpendicular thereto, and a partial framework (20) is thus initially formed, in that the components (30, 40, 41) are installed in the partial framework (20) and are wired therein, the partial framework (20) being completed to form the framework (21), and in that finally the cabinet door (36) and the wall elements (31, 32) are attached to the framework (21) provided with components (30, 40, 41).

2. Method according to claim 1, characterised in that the partial framework (20) is supplemented by upper frame portions (17, 18) and by an additional, preferably prefabricated, frame (22) to form the framework (21).

3. Method according to claim 1 or 2, characterised in that the lower side of the framework (21) is connected to a base (33), and in that the lower side of the framework (21) is closed by partial base plates (34), which are provided with cable inlets (35).

4. Method according to one of claims 1 to 3, characterised in that a mounting plate (30), which is fitted with installation equipment (40), is inserted into the partial framework (20) and is preferably connected to the basic frame (10).

5. Method according to one of claims 1 to 4, characterised in that mounting rails (41) are attached to the partial framework (20).

6. Method according to one of claims 1 to 5, characterised in that assembly carriers are inserted into the partial framework (20) and are wired therein.

7. Method according to one of claims 1 to 6, characterised in that the upper side of the framework (21) is provided with a roof structure.

8. Method according to one of claims 1 to 7, characterised in that a plurality of partial frameworks (20) are disposed in rows adjacent one another, in that the components (30, 40, 41) are introduced into the partial frameworks (20) and wired, the partial frameworks (20) being completed to form frameworks (231), and in that the frameworks (21) are closed by cabinet doors (36) and wall elements (31, 32) to form a row of cabinets.

## Revendications

1. Procédé de réalisation d'une armoire électrique à partir d'une armature ou carcasse constituée de poutrelles, d'au moins une porte d'armoire et d'éléments de cloison, et de pose et de câblage de structures à installer dans l'armoire électrique, telles que des platines de montage, des rails de montage, des modules, des équipements électriques et similaires,
caractérisé
en ce qu'à partir de quatre poutrelles (11, 12, 13, 14) est constitué un cadre de base (10) ou en ce qu'il est utilisé un cadre de base (10) préfabriqué comprenant quatre poutrelles (11, 12, 13, 14)
en ce qu'aux angles inférieurs du cadre de base (10) assemblé sont fixées deux poutrelles supplémentaires (15, 16) perpendiculaires au cadre de base et qu'il est ainsi formé d'abord une carcasse partielle (20),
en ce que dans la carcasse partielle (20) sont montées les structures intérieures (30, 40, 41) qui y sont ensuite câblées, opération au cours de laquelle la carcasse partielle (20) est complétée pour former une carcasse globale (21), et
en ce qu'en fin de compte sont posés la porte d'armoire (36) et les éléments de cloison (31, 32) sur la carcasse globale (21) contenant les structures intérieures (30, 40, 41).

2. Procédé suivant la revendication 1,
caractérisé
en ce que la carcasse partielle (20) est complétée par des poutrelles supérieures (17, 18) et par un cadre complémentaire (22) de préférence préfabriqué pour constituer la carcasse globale (21).

3. Procédé suivant la revendication 1 ou 2, caractérisé en ce que
le côté inférieur de la carcasse (21) est relié à un socle (33), et
en ce que le côté inférieur de la carcasse (21) est fermé par des plaques de base partielles (34), qui présentent des entrées de câble (35).

4. Procédé suivant l'une quelconque des revendications de 1 à 3,
caractérisé
en ce qu'une platine de montage (30) munie d'appareillages (40) est placée dans la carcasse partielle (20) et est de préférence reliée au cadre de base (10).

5. Procédé suivant l'une quelconque des revendications de 1 à 4,
caractérisé
en ce que des rails de montage (41) sont montés sur la carcasse partielle (20).

6. Procédé suivant l'une quelconque des revendications de 1 à 5,
caractérisé
en ce que dans la carcasse partielle (20) sont montés des porte-modules qui y sont câblés.

7. Procédé suivant l'une quelconque des revendications de 1 à 6,
caractérisé
en ce que le côté supérieur de la carcasse (21) est doté d'une structure de toit.

8. Procédé suivant l'une quelconque des revendications de 1 à 7,
caractérisé
en ce que plusieurs carcasses partielles (20) sont accolées,
en ce que les structures intérieures sont placées dans les carcasses partielles (20) et y sont câblées, opération au cours de laquelle les carcasses partielles (20) sont complétées pour constituer une carcasse globale (231), et
en ce que les carcasses globales (21) sont fermées par des portes d'armoire (36) et par des cloisons (31, 32) pour constituer une rangée d'armoires.
